(19)

Europäisches
Patentamt
European
Patent Office
Office européen
des brevets

(11) **EP 3 553 953 A1**

(12) **EUROPEAN PATENT APPLICATION**

(43) Date of publication:
**16.10.2019 Bulletin 2019/42**

(51) Int Cl.:
***H03M 13/45*** (2006.01)

(21) Application number: **18305464.2**

(22) Date of filing: **13.04.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **Université De Reims Champagne-Ardenne 51100 Reims (FR)**
- **Université de Lille 59800 Lille (FR)**
- **Centre National de la Recherche Scientifique 75016 Paris (FR)**

(72) Inventors:
- **DIMANCHE, Vincent 51350 CORMONTREUIL (FR)**
- **GELLE, Guillaume 51500 VILLE EN SELVE (FR)**
- **GOUPIL, Alban 51100 REIMS (FR)**
- **CLAVIER, Laurent 59130 LAMBERSART (FR)**
- **GUZZO BONIFACIO, Salvatore 59800 LILLE (FR)**

(74) Representative: **Nony 11 rue Saint-Georges 75009 Paris (FR)**

(54) **APPROXIMATION OF LOG-LIKELIHOOD RATIOS FOR SOFT DECISION DECODING IN THE PRESENCE OF IMPULSE NOISE CHANNELS**

(57)     Method for processing an encoded signal (S) received from a noisy channel, in particular with impulsive noise in wireless transmission, prior to the decoding of the signal by a decoder, the method comprising:
- applying to the encoded signal (S) a first function ($f_{a,b}$) based on at least two parameters (a, b) depending on the channel noise, for obtaining a modified signal (S') to be decoded, the first function being chosen so as to mitigate the influence of the channel noise during the decoding of the modified signal (S'),
said at least two parameters (a, b) being estimated beforehand by minimizing a second function (J) taking as input a signal (AS) obtained from the encoded signal (S) modified by a processing function using a random binary sequence.

Fig.10

**Description**

The invention is related to methods and systems for processing an encoded signal received from a noisy channel, in particular before the decoding of the encoded signal.

**Background of the invention**

Sensor networks and ad hoc networks are wireless communication networks capable of organizing themselves without previously defined infrastructures. These networks are experiencing developments in many areas, from home applications to military applications. The implementation of these networks particularly in the case where they have a large number of communicating entities, such as several sensor nodes in the case of sensor networks, raises new issues such as the appearance of disturbances in transmission, notably interferences, presenting the peculiarity of being of impulsive nature in sufficiently dense networks.

To mitigate the disturbances of the system, it is necessary to code the information transmitted in a robust manner. It is known to code the information according to an error correction code which adds a redundancy.

Modern codes such as turbo codes or Low Density Parity Check (LDPC) codes can be used, with iterative decoding algorithms, trying to improve the quality of information being decoded iteration after iteration. The decoding of these codes uses as input the signal exiting from the channel, which may be in the form of log likelihood ratio (LLR).

The calculation of the LLR is based on channel modeling and depends largely on the distribution of the additive noise and interference. To do so, it is known to use a Gaussian model, which quickly reaches its limits and poorly matches the multiple communications in a network, i.e. the multiple access interferences generated by the nodes of a sufficiently dense network, which have an impulsive character and strongly influence the quality of the reception of information at the destination nodes. These interferences do not present Gaussian distributions but can be modeled by stable distributions which are characterized by a slower decay of the tails than in the Gaussian case, as described in the article of Hassen Benmaad et al. "Clipping demapper for LDPC decoding in impulsive channel", IEEE Communications Letters, Institute of Electrical and Electronics Engineers, 2013, 17 (5), pp.968-971.

The use of known iterative-based decoding methods is not efficient anymore to transmit information in an impulsive environment and a significant degradation of the performances of these methods appears and affects the reliability of the decoding of the information. The mismatch between the assumption made to design the receiver and the true interference distribution makes the decoding inefficient.

However, the main difficulty of changing the metric lies in the fact that the distribution of the interference is not necessarily a priori known. It depends on the network configuration, for instance the density of users and the design of the layers of Media Access Control (MAC). If stable distribution is quite a general model, there is not however an explicit form of the density, making the LLR extremely complex to compute.

The article of Poulliat C. et al, "Performances des codes LDPCpour l'Ultra-Large Bande (ULB) impulsionnelle sous approximation gaussienne généralisée des interférences », in the proceedings of GRETSI conference, 2007, shows the use of a generalized Gaussian approximation of multi-users interferences. The type of considered impulsivity is quite specific and renders the approximation more restrictive.

The article of Chuan Hsian, "Iterative SOVA decoding over alpha stable channels", Journal of Engineering Science and Technology, June 2012, vol. 7(3) describes the use of a Cauchy-Bayesan metric. The article of Chuan Hisian, « SOVA decoding in Symmetric Alpha-Stable Noise », Symposium on Information & Computer Sciences, 2011, describes the use of Cauchy function in the path-metric. The Cauchy density is a special case of stable distribution but assumes a high impulsivity and is not adapted to low levels of impulsivity.

The article of M. Johnston et al., «Sum-Product Algorithm Utilizing Soft Distances on Additive impulsive Noise Channels », in IEEE Transactions on Communications, vol. 61, no. 6, pp. 2113-2116, June 2013., describes an adapted Sum-Product Algorithm (SPA) increasing the performances with respect to already-known SPA. It modifies the decoding algorithm in a deep manner, which implies a great complexity.

The known p-norm is an advantageously chosen solution because it only requires a rough estimate of the stable distribution, and not the estimation of the noise parameters

The article of Wei Gui, "Decoding Metric Study for Turbo Codes in Very impulsive Environment", in IEEE Communications Letters, vol. 16, no. 2, pp. 256-258, February 2012, describes the utilization of the p-norm. This norm leads to good performances, but is quite complex to implement.

**Summary**

There thus remains a need to further increase decoding performances in the case of transmission over a noisy wireless channel. More specifically, there is a need to reduce the impact that high intensity and low duration noises, also called impulsive noise, can have on the decoding process. Reduction of such an impact can improve the amount of data packets successfully decoded by a receiver, or, equivalently, reducing the packet error rate.

The invention aims at satisfying this need by providing a method for processing an encoded signal S received from a noisy channel, in particular with impulsive noise in wireless transmission, prior to the decoding of the signal by a decoder, the method comprising:

- applying to the encoded signal S a first function $f_{a,b}$ based on at least two parameters *a, b,* depending on the channel noise, for obtaining a modified signal S' to be decoded, the first function being chosen so as to mitigate the influence of the channel noise during the decoding of the modified signal S',

wherein said at least two parameters *a, b,* are estimated beforehand by minimizing a second function *J* taking as input a signal *AS* obtained from the encoded signal S modified by a processing function using a random binary sequence.

The signal processing of the invention provides a generic method that can be implemented on many different types of receivers. It does not necessitate modification in the transmitter and can simply be added to existing protocols at the receiver side. It also has the advantage of not degrading communications in case of traditional communication conditions with a simple thermal Gaussian noise. Furthermore, the method is self-adaptive and can be used in many different settings, with different noise distributions.

The processing method according to the invention provides better results than state-of-the-art methods, allowing obtaining much more correctly decoded packets. The improvement is particularly significant if noise has an impulsive behavior.

Synchronization

Transmitters and receivers used for implementing the method according to the invention are usually driven by separate hardware clocks, the carrier frequency set up at the transmitter and the receiver sides may not be exactly the same. It is thus advantageous to perform a step of synchronization, for estimating and correcting carrier shift that may be introduced, to generate the encoded signal S.

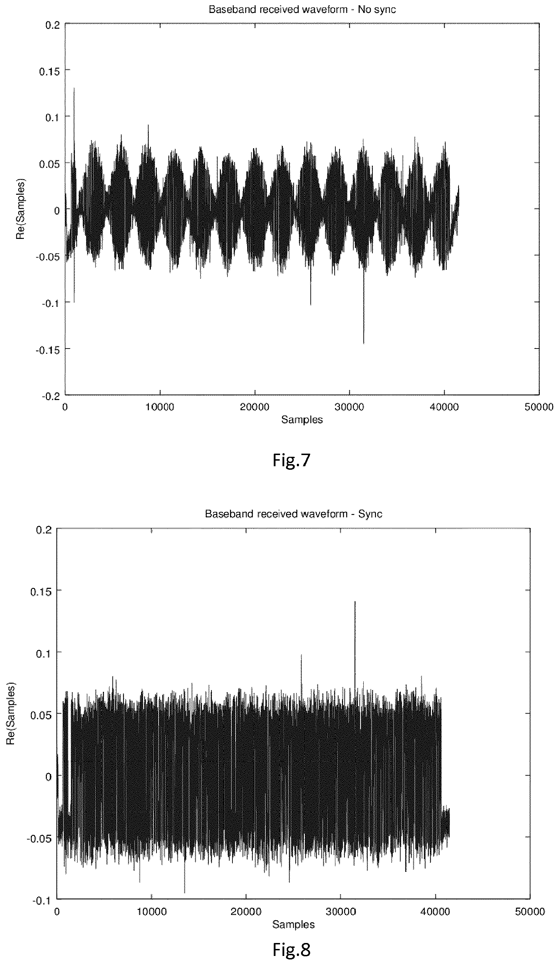

The synchronization included in state-of-the-art systems is capable to apply the necessary correction in the case of noiseless signals or with a low level of noise. In the case of noisy signals, especially with impulsive noise, the default correction mechanism is not precise enough. An example of a BPSK modulated signal, with the presence of carrier offset, is illustrated in Fig. 7. The signal is composed of around 40000 samples, with a carrier offset of approximately 140Hz. The presence of carrier impairment produces the identified effect in the image: the amplitude, affected by noise, is not regular, and seems almost modulated, with a sinusoidal shape for the envelop. Carrier shift effect is also visible in constellation diagrams, with the spread of the samples in a circle.

In order to compensate the carrier offset, a synchronization metric $\mathcal{M}$ may be introduced, defined as:

$$\mathcal{M} = \text{mean}\left(\text{abs}\left(\mathfrak{I}\left(S_c^{\Delta f}\right)\right)\right),$$

where $S_c^{\Delta f}$ represents the corrected sampled sequence from the encoded signal S, using a $\Delta f$ offset, $\mathfrak{I}$ indicates the imaginary part of the complex number, whereas *abs* and *mean* represent absolute value and average operations respectively. Corrected sampled sequence may be obtained by shifting every sample of a $\Delta f$ offset, in frequency, and defined as:

$$S_c^{\Delta f} = \sum_k \left(S_k * e^{i2\pi * \Delta f * kT_s}\right),$$

where $T_s$ represents the sampling time. For the estimation and correction operation, an iterative process is advantageously defined, performed over a range of frequencies $\Delta_f^{min} \leq \Delta_f \leq \Delta_f^{Max}$, in order to obtain frequency offset correction.

The aforementioned loop may be composed of the following steps: apply a temporary offset correction $\Delta_f$, as defined above, estimate phase shift of the constellation, using for example linear approximation, compensate estimated phase shift, and compute synchronization metric $\mathcal{M}$ as defined above.

Once all the synchronization metrics are collected, the frequency offset that allows minimizing the average dispersion over the imaginary coordinate of the complex space may be selected to be applied to the sampled signal under analysis, following the expression below:

$$Offset = \operatorname*{argmin}_{\Delta f}(\mathcal{M}).$$

By applying this kind of synchronization, it is possible to obtain corrective measures that are effective in a wider noise scenario, compared with the known solutions.

<u>Symbols and amplitudes</u>

Preferably, the encoded signal $S$ comprises a plurality of symbols $a_k$, the first function being applied to an amplitude $x$ associated to each symbol. The encoded signal S can be expressed as: $S(t) = \Sigma_k a_k h(t - kT_{symb}) + n(t)$, where $a_k$ are the sent symbols at rate $T_{symb}$, $h(t)$ is a filter comprising a shaping filter and a channel filter, and $n(t)$ is the noisy part.

After the synchronization, a matched filtering may be applied in order to minimize Inter-Symbol Interference, followed by a decimation operation for extracting, from the oversampled signal, one sample per symbol. The encoded signal S may thus be sampled with a number of $n$ samples ($S_1, S_2, ......, S_n$) per symbol, $n$ being an integer, for example $n$=8, the number of samples per symbol being preferably reduced to one sample per symbol during a decimation step.

A step of symbol synchronization may be used to detect the synchronization sequence, which depends on the used protocol and is included in the encoded signal in order to identify the beginning of the useful data, also called "payload". In state-of-art systems, a PSK Detect step is responsible for the analysis of the signal, in order to associate one of the admissible point in the constellation to each symbol of the sequence. In the case of a BPSK modulation, only two symbols are possible and a positive value will be associated to 1 when a negative value will be associated to 0. A step of symbol demapping then transforms the symbol sequence to a binary sequence, which corresponds to the output for the decoding. When a Forward Error Correction code is used, such a binary decision is not optimal, and a soft decision, that is to say based on real values, is preferable.

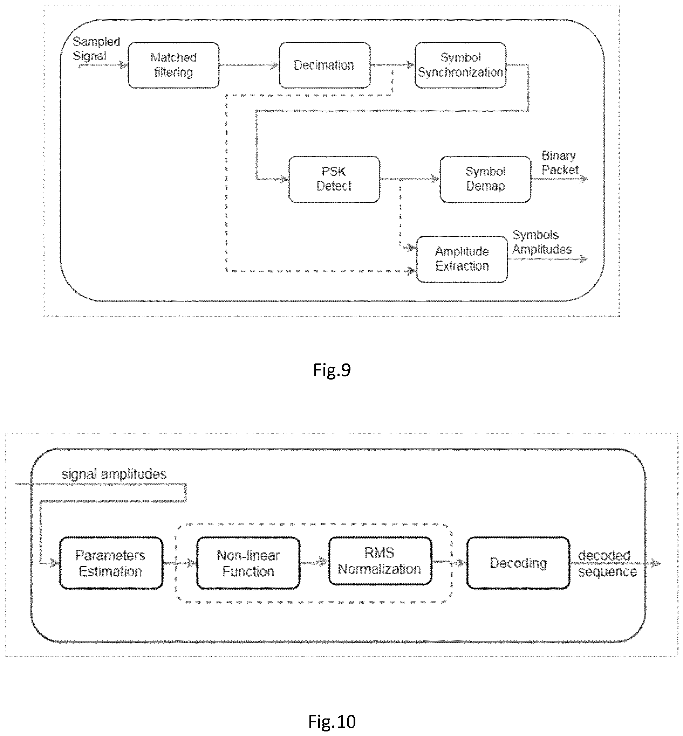

The quantized decimated values, along with some information received from the PSK detect step to correct the phase shift, may be used for extract amplitudes, as can be seen in Fig. 9.

The method may comprise normalizing the amplitudes of the encoded signal S before estimation of the parameters a, b, and application of the first function $f_{a,b}$.

The amplitude normalization may be obtained through division of the amplitudes of the sampled symbols by

$$A = \frac{\overline{|Sync_R|}}{\overline{|Sync_D|}},$$

an attenuation factor, preferably defined by wherein $Sync_R$ represents a received synchronization sequence and $Sync_D$ represents a default synchronization sequence, preferably represented by default BPSK symbol +1 and -1 in the case where a BPSK modulation has been applied to the encoded signal, and $\overline{|X|}$ being an average absolute

$$\overline{|X|} = \frac{\sum_{i=1}^{n}|X_i|}{n},$$

amplitude defined by for a sequence X of n samples $X_1, X_2, ......, X_n$. Such amplitude normalization is useful to compensate path loss attenuation, due to the propagation of the signal over the channel, in particular in case of a wireless channel.

<u>First and second functions</u>

The first function is preferably a non-linear function providing a parametrized approximation of log likelihood ratio.

The first function may be defined by:

$$f_{a,b}(x) = min(a \cdot |x|, \frac{b}{|x|}) \cdot sign(x),$$

wherein $x$ is the amplitude of the received symbol under analysis, and $a$ and $b$ are the beforehand-estimated parameters.

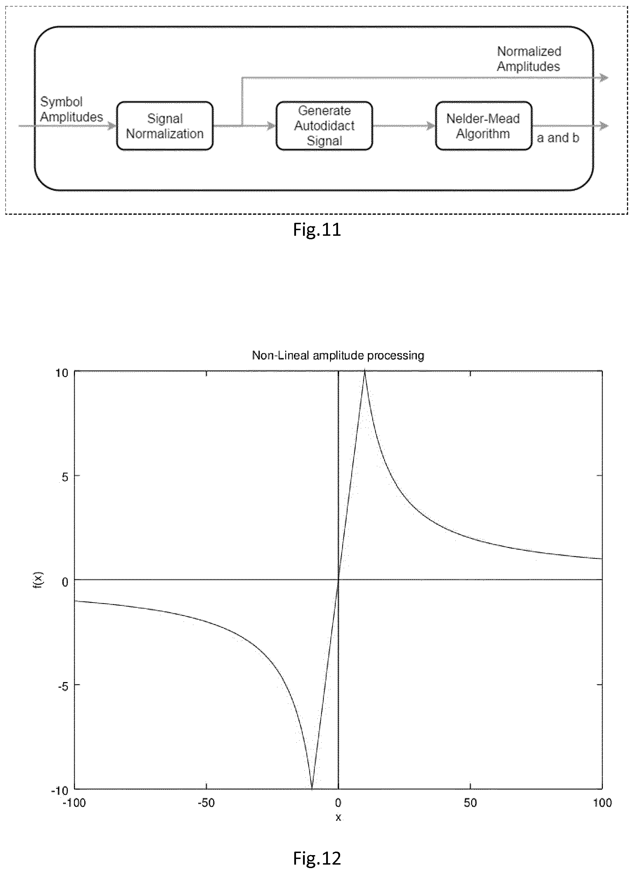

An example of the first function $f_{a,b}$ is represented in Fig. 12. As visible, all input amplitudes $x$ in absolute value that are below a threshold $s_x$ are preferably processed using a linear part of the first function $f_{a,b}$, and all amplitudes $x$ that exceed said threshold $s_x$ are processed using an hyperbola type part of the first function $f_{a,b}$. The threshold may be

$$s_x = \sqrt{\frac{b}{a}}.$$

defined by

The second function J may be defined by a cost function $J(a,b)$ of the first function $f_{a,b}$, the parameters $a, b$ being estimated such that $(a,b) = argmin\ J(a,b)$.

$$J(a,b) = \frac{\sum_{i=1}^{n} ln(1+e^{-f_{a,b}(AS_i)})}{n},$$

Preferably, the cost function $J$ is defined by $\qquad$ wherein $f_{a,b}$ is the first function, and $AS_i$ are the amplitudes of the input signal $AS$ obtained from the encoded signal $S$ modified by a processing function using a random binary sequence.

The method may comprise normalization of the samples of the modified signal S', in particular by computing

$$f_{a,b}(x) = \frac{f_{a,b}(x)}{RMS(f_{a,b}(x))},$$

a RMS value, the normalized modified signal S' being defined by no*rmalized* $\qquad$ with

$$RMS(x) = \sqrt[2]{\frac{\sum_m |x_m|^2}{m}},$$

wherein m is the number of samples available after processing by the first function $f_{a,b}$.

The linear part of the first function $f_{a,b}$, as can be seen in Fig. 12, may be determined by a slope that can introduce a non-negligible amplification effect on the output signal. This amplification may introduce amplitude values out of the admissible range of the decoding algorithm. This normalization operation on the modified signal S' is useful to resize overall amplitudes and re-establish the limits within tolerable boundaries. The normalized samples keep the original shape of the non-normalized samples but with an adapted dynamic range.

Estimation *of a, b* parameters

The goal is to estimate the values of $a$ and $b$ that can optimize the mutual information based on the channel condition estimated for the encoded signal $S.$

The coefficient $a$ and $b$ may be estimated using an information theory criterion in order to maximize the mutual information between the encoded signal and the sequence after the non-linear mapping, based on a learning sequence.

Preferably, the estimation of the parameters $a, b$ is performed by a non-linear optimization algorithm, preferably a Nelder-Mead algorithm. Other algorithms may be used, for example a search on a predefined grid.

An initial guess of the parameters $a, b$ may be defined before the first iteration of the minimization of the second function ($J$), for example by setting $a = 4$ and $b = 6$.

Input signal *AS*

The input signal *AS* for the estimation of the parameters $a, b$ is called *"autodidact signal"*. This signal corresponds to an approximated isolation of the estimated noise component introduced by the channel.

The input signal $AS$ for the estimation of the parameters $a, b$ may be generated by the following expression: $AS_k = 1 + n'_k$ wherein $n'_k$ is a training sequence defined by $n'_k = n_k \cdot r_k$, with $n_k = y_k - sign(y_k)$, $r_k$ being a random binary sequence distributed in {-1, 1}, and $y_k$ being the $k^{th}$ normalized amplitude of the encoded signal $S.$

System

The invention also provides a system for processing an encoded signal $S$ received from a noisy channel, in particular with impulsive noise in wireless transmission, prior to the decoding of the signal by a decoder, the system comprising:

- a signal processing module adapted for applying to the encoded signal S a first function based on at least two parameters for obtaining a modified signal $S'$, the first function being chosen so as to mitigate the influence of the channel noise during the decoding of the modified signal, and
- a parameter estimation module adapted for estimating said at least two parameters beforehand by minimization of a second function taking as input a signal $AS$ obtained from the encoded signal $S$ modified by a processing function using a random binary sequence.

The system may further comprise a module adapted for normalizing the amplitudes of the encoded signal $S$ before estimation of the parameters $a, b$ and application of the first function $f_{a,b}$.

The system may comprise a module adapted for normalizing the samples of the modified signal ($S'$), in particular by computing a RMS value, the normalized modified signal (*S'*) being defined by *Normalized* $f_{a,b}(x) = \frac{f_{a,b}(x)}{RMS(f_{a,b}(x))}$,

with $RMS(x) = \sqrt[2]{\frac{\sum_m |x_m|^2}{m}}$, wherein *m* is the number of samples available after processing by the first function $f_{a,b}$.

The features defined above for the method apply to the system and vice-versa.

## Computer program product

The invention also provides a computer program product for processing an encoded signal *S* received from a noisy channel, in particular with impulsive noise in wireless transmission, prior to the decoding of the signal by a decoder, the computer program product comprising a support and stored on this support instructions that can be read by a processor, these instructions being configured for:

- applying to the encoded signal *S* a first function based on at least two parameters for obtaining a modified signal *S'* to be decoded, the first function being chosen so as to mitigate the influence of the channel noise during the decoding of the modified signal *S'*, and
- estimating beforehand said at least two parameters by minimizing a second function taking as input a signal *AS* obtained from the encoded signal *S* modified by a processing function using a random binary sequence.

The features defined above for the method and the system apply to the computer program product.

## Brief description of the drawings

The invention will be better understood on reading the following detailed description of non-limiting exemplary embodiments thereof and on examining the appended drawings in which:

- Figure 1 illustrates schematically an example of hardware system components for the transmission and reception of packets over a wireless network,
- Figures 2 and 3 are respective block diagrams of the implementation steps of a USRP at the transmitter and receiver sides,
- Figure 4 illustrates an example of a receiver block diagram,
- Figure 5 shows an example of parallel processing for signal extraction,
- Figure 6 is a block diagram showing some steps for extracting amplitudes according to the invention,
- Figure 7, previously described, illustrates an example of a received baseband signal with carrier offset according to the state-of-the-art,
- Figure 8 shows the result, in time domain, of the synchronization algorithm according to the invention,
- Figure 9, previously described, shows a demodulation and amplitude extraction block diagram according to the invention,
- Figure 10 is a block diagram showing some steps of the method for processing an encoded signal according to the invention,
- Figure 11 is a block diagram showing some steps of the estimation of parameters depending on the channel noise according to the invention, and
- Figure 12, previously described, illustrates an example of a non-linear function first function according to the invention.

## Detailed description

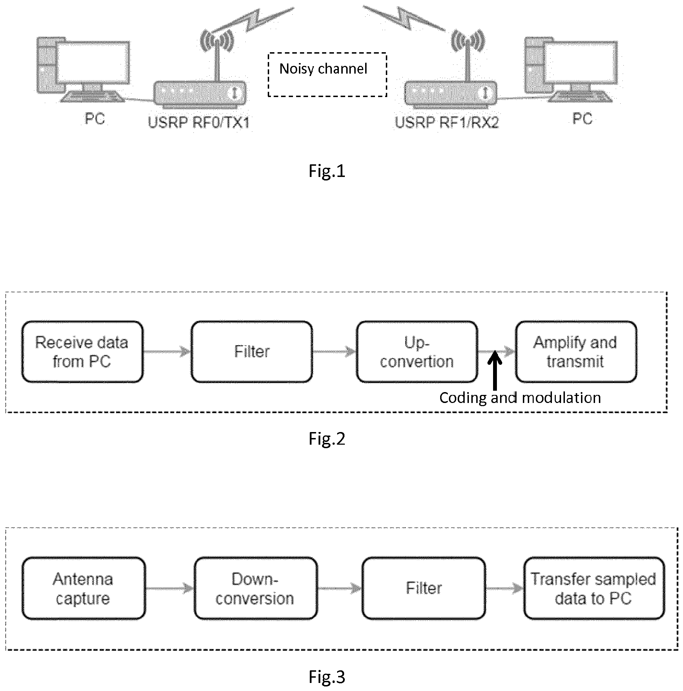

As illustrated in Fig.1, an example of a system used in the invention for the transmission and reception of packets over a wireless network comprises an universal software radio peripheral (USRP) and an associated driving computer (PC) at the transmitter side, and a USRP and a PC at the receiver side. The packets are transmitted over a noisy wireless channel. The invention is not limited to wireless transmissions, and can apply to non-wireless transmissions, for example in Power-Line communications or acoustic transmissions. The USRPs in use are for example NI-USRP 2952R. The invention is not limited to the use of a USRP, and a system-on-chip, a DSP or FPGA may also be used. Preferably, a single USRP equipped with two independent radio interfaces is used to send and receive the signal. In this case, synchronization between transmitter and receiver is automatically achieved due to the share of the same clock at transmitter and receiver sides.

The operations performed by the hardware inside the USRP can be abstracted both for transmission and for reception of signals as illustrated in Fig. 2 and Fig. 3 respectively. These operations are necessary for the conversion of the signal between baseband and passband and vice versa. In the present invention, bands centered in 915 MHz and 2.45 GHz may be used, corresponding to bands of Industrial Scientific and Medical bands (ISM). The invention is however not limited to specific carrier bands.

In order to transmit a signal over a communication medium, it is necessary to transpose it from the baseband, which is centered around 0Hz, to the desired passband. To do so, the USRP receives the waveform to transmit from the computer, filters and transposes, in a step of up-conversion, the spectrum of the signal. The signal is then encoded and modulated. The signal in passband is amplified prior to be directed toward the antenna to be transmitted over the wireless medium.

The operations to be performed at the reception are meant to revert the process performed by the transmitter. In this example, in the receiving chain of the USRP, the signal captured by the antenna is amplified using a low noise amplifier. In a step of down-conversion, the received signal is transposed back to baseband applying the same carrier frequency used by the transmitter. A filtering of the down converted signal is advantageously performed in order to retain only the frequencies of interest. The filtered signal is then sampled and transferred to the computer to be further processed.

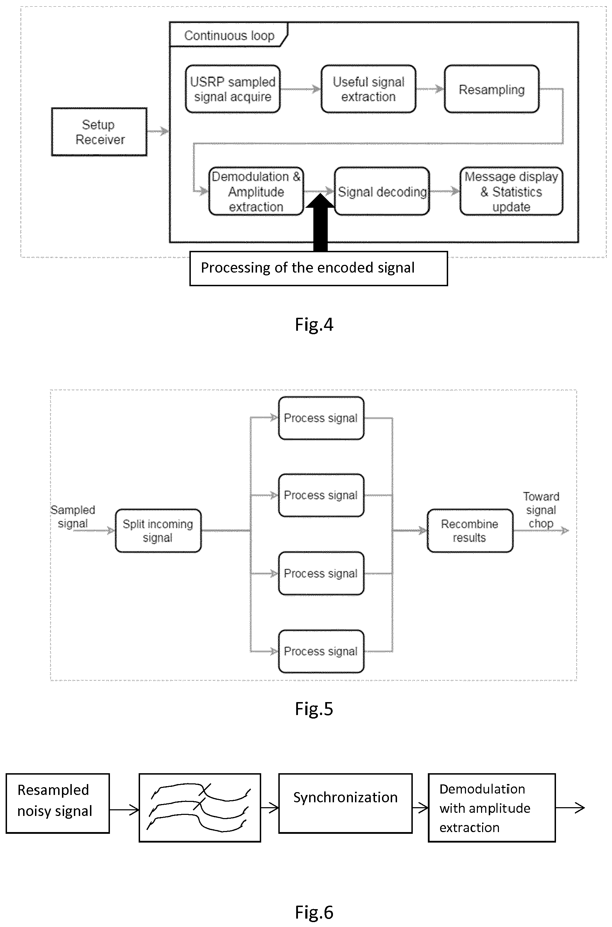

The general structure of the receiver application which can be used for the implementation of the invention is represented by the block diagram of Fig. 4.

A step for establishing the setup of the receiver is performed once at startup, similarly to the one at the transmitter, by initializing the USRP with parameters such as carrier frequency, sampling frequency, or amplification factor. During such step, it is also possible to qualify some of the properties that are specific to the coding technique in use.

The next step is to acquire the baseband sampled signal produced by the USRP. In this example, the data type is an array of complex numbers containing the In-Phase and Quadrature (I/Q) components of each sample, obtained by the down-conversion, as the real and imaginary part of a complex number. The structure of the received signal can be expressed as:

$$R(t) = \sum_{k} (I_k + jQ_k) \cdot \delta(t - kT_s)$$

where $T_s$ represents the sampling time.

Due to its structure, the USRP is continuously down-converting and sampling what is detected. Consequently, the received sampled signal may or may not contain an actual transmission. Hence, a step of extracting useful signal may be performed, in order to estimate the signal and noise level, for extracting from all received samples only those that are likely to carry out a message. This is meant to reduce the execution time avoiding to process samples containing merely noise. In order to improve efficiency in signal processing and, consequently, being able to achieve real time decoding, a parallelized signal analysis may be implemented, as depicted in Fig. 5. Each *"Process signal"* component of parallel processing is in charge to detect boundaries for the presence of a packet. All results are recombined to produce boundaries, and used to create set of samples to be further analyzed. The remaining have been estimated to contain just channel noise.

The signal may then be subjected to another sampling process, as shown in Fig. 4. This is useful to have the correct number of samples per symbol necessary for the further demodulation step. Even though the sampling frequency is often a configurable parameter at the transmitter side, there can be a difference between the requested sampling frequency and the actual sampling frequency, due to hardware limitations. Thus, resampling may be performed to eliminate possible impairments.

A further step of demodulation and amplitude extraction, which can be decomposed as illustrated in Fig. 6, is performed in the illustrated example. The resampled noisy signal is preferably low-pass filtered prior to continue further in the demodulation chain, to form the encoded signal S.

As previously described, it is advantageous to perform a step of synchronization, for estimating and correcting carrier shift that may be introduced. Fig. 8 shows the result of this synchronization step, performed on the encoded signal S, in time domain.

A step of BPSK demodulation with amplitude extraction, previously described, and detailed in Fig. 9, is performed in order to extract amplitude associated to every symbol of the encoded signal S. This amplitude sequence will be the input for non-linear operation performed in the invention.

The method for processing the encoded signal according to the invention, marked by the black arrow of Fig. 4, will be further detailed below.

Once the encoded signal has been processed, the transmitted message is retrieved in a step of signal decoding.

The validity of the decoded sequence may be verified in a step of "Message display & statistics update". In this example, the sequence is subjected to a verification of the cyclic redundancy check (CRC) code added as tail of the payload at the transmitter side. If such verification is successfully passed, the payload, the essential data that is being carried within a packet, is extracted, converted in the string format and displayed for the user. The reception statistics may be updated to keep count of the current received packet as successfully or unsuccessfully decoded.

An example of detailed steps for processing the encoded signal S according to the invention is shown in Fig. 10.

As previously described, a first step is the beforehand estimation of parameters $a$, $b$ depending on the channel noise, which are necessary to properly configure the computation of the non-linear first function $f_{a,b}$, followed by an operation of RMS normalization, before the obtaining of the decoded sequence by a decoding step. This step uses the second function $J$ that is a cost function $J(a,b)$ of the first function $f_{a,b}$, the parameters $a$, $b$ being estimated such that $(a,b) = argmin\ J(a,b)$, by using, preferably and as shown in Fig.11, a particular type of simplex method known as Nelder-Mead algorithm. It makes use of three points, in a bidimensional space, that are relocated during the iterations of the algorithm in order to obtain the estimated optimized pair $a$, $b$.

Preferably, as previously described and as shown on Fig. 11, for achieving the estimation of the parameters $a$, $b$, a preliminary operation of amplitude normalization is realized.

Once obtained the normalized amplitudes, as previously described, the autodidact Signal $AS$ is generated by the following expression: $AS_k = 1 + n'_k$, wherein $n'_k$ is a training sequence defined by $n'_k = n_k \cdot r_k$, with $n_k = y_k - sign(y_k)$, $r_k$ being a random binary sequence distributed in {-1, 1}, and $y_k$ being the $k^{th}$ normalized amplitude of the encoded signal S. This signal $AS$ is used as input for the cost function $J(a,b)$, by defining an initial guess for parameters $a$ and $b$, for example $a = 4$ and $b = 6$.

Preferably and as previously described, to every amplitude $x$ of every symbols under analysis, is applied a non-linear function

$$f_{a,b}(x) = \min\left(a \cdot |x|, \frac{b}{|x|}\right) \cdot sign(x),$$

as illustrated in Fig. 12, for obtaining a modified signal S' to be decoded. In this example, all input amplitudes $x$ in absolute value that are below a threshold $s_x$ are processed using a linear part of the first function $f_{a,b}$, and all amplitudes $x$ that exceed said threshold $s_x$ are processed using an hyperbola type part of the first function $f_{a,b}$. The threshold may be defined by: $s_x = \sqrt{\dfrac{b}{a}}$.

In the illustrated example, a normalization of the samples of the modified signal S' is performed, by computing a RMS value, the normalized modified signal S' being defined by no*rmalized* $f_{a,b}(x) = \dfrac{f_{a,b}(x)}{RMS(f_{a,b}(x))},$ with

$$RMS(x) = \sqrt[2]{\frac{\sum_m |x_m|^2}{m}},$$

wherein m is the number of samples available after processing by the first function ($f_{a,b}$).

The processing of the encoded signal S according to the invention is then concluded, the produced output may be adopted to perform decoding, as above-written.

Decoding performance tests are now going to be presented. In the following test examples, a single USRP equipped with two independent radio interfaces is used, and received signals have been added with $\alpha$-stable random noise aiming to simulate an impulsive channel noise. Such a noise depends on several parameters. $\alpha$ is the characteristic exponent of the probability distribution function. For an $\alpha$-stable distributed noise, a lower $\alpha$ implies a higher impulsivity of the noise. $\beta$ indicates the skewness, $\gamma$ is used as a scale parameter, allowing to adjust the produced noise in amplitude, and $\delta$ is defined as a location parameter introducing a shifting offset. All test presented hereafter have been produced using $\beta = 0$ and $\delta = 0$.

Tests have been performed using three different coding techniques, more precisely Low Density Parity Check (LDPC) coding, Convolutional coding and Turbo codes.

The results, presented in table form indicating main configuration parameters, are grouped based on the type of coding technique under evaluation. The tables represent the percentage of correctly decoded packets; that is to say which have a CRC check with positive result. Results for *pure decoding*, using amplitudes without applying any further processing, for *classic LLR decoding*, amplitudes processed using a standard equation for the computation of the LLR,

$$LLR(c_i) = \ln\left(\frac{Pr(c_i=0\ |\ y)}{Pr(c_i=1\ |\ y)}\right)$$

with $c_i$ the expected code word and $y$ the channel output, used with a normal distribution with $\sigma = 0.8$, and for the method according to the invention are presented and compared.

Table 1: LDPC coding

|  | Pure decoding | Classic LLR decoding | Invention | Average SNR |
|---|---|---|---|---|
| Alpha=1.7 Gamma=0.04 Size= 13 Bytes | 45.98% | 91.56% | 98.57% | 1.19 dB |
| Alpha=1.7 Gamma=0.05 Size= 13 Bytes | 17.79% | 81.83% | 95.06% | -1.55 dB |
| Alpha=1.6 Gamma=0.06 Size= 13 Bytes | 10.62% | 77.86% | 92.72% | -2.80 dB |
| Alpha=1.6 Gamma=0.07 Size= 13 Bytes | 1.2% | 56.75% | 74.04% | -4.78 dB |

Table 2: Convolutional coding - short payload

|  | Pure decoding | Classic LLR decoding | Invention | Average SNR |
|---|---|---|---|---|
| Alpha=1.7 Gamma=0.08 Rate=1 /2 Size= 40 Bytes | 78% | 77.99% | 96.91% | -2.4 dB |
| Alpha=1.7 | 54.25% | 54.26% | 89.4% | -3.86 dB |
| Gamma=0.09 Rate=1 /2 Size = 40 Bytes |  |  |  |  |
| Alpha=1.6 Gamma=0.05 Rate=1 /2 Size = 40 Bytes | 65.2% | 65.22% | 94.07% | -1.79 dB |

Table 3: Convolutional coding - medium payload

|  | Pure decoding | Classic LLR decoding | Invention | Average SNR |
|---|---|---|---|---|
| Alpha=1.6 Gamma=0.05 Rate=1 /2 Size = 400 Bytes | 8.58% | 8.42% | 92.03% | -2.15 dB |
| Alpha=1.6 Gamma=0.05 Rate=1 /3 Size = 400 Bytes | 23.55% | 22.32% | 93.78% | 4.71 dB |

Table 4: Convolutional coding - long payload

| | Pure decoding | Classic LLR decoding | Invention | Average SNR |
|---|---|---|---|---|
| Alpha=1.6 Gamma=0.05 Rate=1 /2 Size = 600 Bytes | 4.61% | 4.51% | 90.85% | -2.44 dB |
| Alpha=1.6 Gamma=0.05 Rate=1 /3 Size = 600 Bytes | 9.88% | 9.22% | 93.23% | 4.93 dB |

Table 5: Turbo coding

| | Pure decoding | Classic LLR decoding | Invention | Average SNR |
|---|---|---|---|---|
| Alpha=1.6 Gamma=0.03 Rate=1/2 (punct.) Size = 13 Bytes | 36.45% | 65.80% | 79.27% | -1.59 dB |
| Alpha=1.6 Gamma=0.04 Rate=1 /3 Size = 13 Bytes | 24.52% | 55.18% | 76.12% | -3.31 dB |
| Alpha=1.6 Gamma=0.05 Rate=1 /3 Size = 13 Bytes | 3.65% | 30.87% | 53.23% | -6.91dB |

From these results, it is obvious that the processing method according to the invention provides better results than state-of-the-art methods. From 13% up to 80% of additional correctly decoded packets can be obtained.

Performances of the automatic estimation of the channel configuration parameters according to the invention are also shown, in order to determine the improvement in terms of decoding capabilities and to validate the implemented channel estimation technique.

All tests have been performed using convolutional coding technique, with $\beta = 0$ and $\delta = 0$, and the results are presented in table form, indicating main configuration parameters.

In this example, transmitter and receiver are played by two completely separated couples of USRP and controlling unit. In such configuration, the two systems do not share the same clock, hence the synchronization operations are important to allow a proper analysis of the processed sampled signal $S'$. The tables represent the percentage of correctly decoded packets, for pure decoding, for classic LLR decoding, for a processing according to the invention but with theoretical a and b parameters mathematically calculated by $a = \dfrac{\sqrt[2]{2}}{\gamma}$ and $b = 2 \cdot \sqrt[2]{\alpha + 1},$ and for the parameters estimation method according to the invention.

Table 6: Convolutional coding - $\alpha$=1.7

| | Pure decoding | Classic LLR decoding | Theoretical parameters estimation | Invention | Average SNR |
|---|---|---|---|---|---|
| Alpha=1.7 Gamma=0.01 Rate=1 /2 Size = 150 Bytes | 72.27% | 72.28% | 90.48% | 84.39% | 6.48 dB |

(continued)

|  | Pure decoding | Classic LLR decoding | Theoretical parameters estimation | Invention | Average SNR |
|---|---|---|---|---|---|
| Alpha=1.7 Gamma=0.03 Rate=1 /2 Size = 150 Bytes | 18.71% | 18.71% | 58.79% | 61.30% | -11.04 dB |
| Alpha=1.7 Gamma=0.05 Rate=1 /2 Size = 150 Bytes | 0.91% | 0.9% | 9.68% | 13.23% | -12.41 dB |

Table 7: Convolutional coding - $\alpha$=1.8

|  | Pure decoding | Classic LLR decoding | Theoretical parameters estimation | Invention | Average SNR |
|---|---|---|---|---|---|
| Alpha=1.8 Gamma=0.01 Rate=1 /2 Size = 150 Bytes | 50.16% | 50.16% | 69.25% | 76.45% | 1.55 dB |
| Alpha=1.8 Gamma=0.03 Rate=1 /2 Size = 150 Bytes | 53.58% | 53.58% | 83.54% | 77.45% | -4.95 dB |
| Alpha=1.8 Gamma=0.05 Rate=1 /2 Size = 150 Bytes | 7.58% | 7.58% | 26.50% | 33.84% | -9.17 dB |

Table 8: Convolutional coding - $\alpha$=1.9

|  | Pure decoding | Classic LLR decoding | Theoretical parameters estimation | Invention | Average SNR |
|---|---|---|---|---|---|
| Alpha=1.9 Gamma=0.01 Rate=1 /2 Size = 150 Bytes | 94.26% | 94.26% | 97.36% | 96.55% | 12.46 dB |
| Alpha=1.9 Gamma=0.03 Rate=1 /2 Size = 150 Bytes | 70.19% | 70.19% | 84.64% | 80.05% | -5.21 dB |
| Alpha=1.9 Gamma=0.05 Rate=1 /2 Size = 150 Bytes | 14.39% | 14.39% | 24.55% | 29.46% | -11.56 dB |

Table 9: Convolutional coding - Natural thermal noise

| | Pure decoding | Classic LLR decoding | Non-linear theoretical | Non-linear estimated |
|---|---|---|---|---|
| Rate=1 /2 Size = 150 Bytes | 98.63% | 98.63% | 98.63% | 98.63% |

From these results, it is obvious that the estimated parameters according to the invention do not degrade the decoding performances, and even improve these performances most of the time.

**Claims**

1. Method for processing an encoded signal (S) received from a noisy channel, in particular with impulsive noise in wireless transmission, prior to the decoding of the signal by a decoder, the method comprising:

   - applying to the encoded signal (S) a first function ($f_{a,b}$) based on at least two parameters (a, b) depending on the channel noise, for obtaining a modified signal (S') to be decoded, the first function being chosen so as to mitigate the influence of the channel noise during the decoding of the modified signal (S'),

   said at least two parameters (a, b) being estimated beforehand by minimizing a second function (*J*) taking as input a signal (*AS*) obtained from the encoded signal (S) modified by a processing function using a random binary sequence.

2. The method according to claim 1, wherein the encoded signal (S) comprising a plurality of symbols, the first function ($f_{a,b}$) being applied to an amplitude (*x*) associated to each symbol.

3. The method according to claim 2, wherein the first function ($f_{a,b}$) is a non-linear function defined by:

$$f_{a,b}(x) = min(a \cdot |x|, \frac{b}{|x|}) \cdot sign(x),$$

   wherein *x* is the amplitude of the symbol under analysis, and *a* and *b* are the beforehand-estimated parameters (a, b).

4. The method according to the preceding claim, wherein all input amplitudes (*x*) in absolute value that are below a threshold ($s_x$) are processed using a linear part of the first function ($f_{a,b}$), and all amplitudes (*x*) that exceed said threshold ($s_x$) are processed using an hyperbola type part of the first function ($f_{a,b}$).

5. The method according to the preceding claim, wherein the threshold ($s_x$) is defined by $s_x = \sqrt{\frac{b}{a}}.$

6. The method according to any one of the preceding claims, wherein the encoded signal (S) is sampled with a number of *n* samples ($S_1$, $S_2$, ...... , $S_n$) per symbol, *n* being an integer, for example *n*=8, the number of samples per symbol being preferably reduced to one sample per symbol during a decimation step.

7. The method according to claim 6, wherein the second function (*J*) is defined by a cost function *J(a,b)* of the first function ($f_{a,b}$), the parameters (a, b) being estimated such that (a,b) = *argmin J(a,b)*.

8. The method according to the preceding claim, wherein the cost function (*J*) is defined by

$$J(a,b) = \frac{\sum_{i=1}^{n} ln(1+e^{-f_{a,b}(AS_i)})}{n},$$ wherein ($f_{a,b}$) is the first function, and $AS_i$ are the amplitudes of the input signal (*AS*) obtained from the encoded signal (S) modified by a processing function using a random binary sequence.

9. The method according to any one of claims 2 to 8, comprising normalizing the amplitudes of the encoded signal (S) before estimation of the parameters (a, b) and application of the first function ($f_{a,b}$).

10. The method according to claim 8, wherein the input signal ($AS$) for the estimation of the parameters ($a$, $b$) is generated by the following expression: $AS_k = 1 + n'_k$ wherein $n'_k$ is a training sequence defined by $n'_k = n_k \cdot r_k$, with $n_k = y_k - sign(y_k)$, $r_k$ being a random binary sequence distributed in {-1, 1}, and $y_k$ being the $k^{th}$ normalized amplitude of the encoded signal (S).

11. The method according to any one of the proceeding claims, wherein the estimation of the parameters ($a$, $b$) is performed by a non-linear optimization algorithm, preferably a Nelder-Mead algorithm.

12. The method according to the preceding claim, wherein an initial guess of the parameters ($a$, $b$) is defined before the first iteration of the minimization of the second

13. The method according to claim 6, comprising normalization of the samples of the modified signal (S'), in particular by computing a RMS value, the normalized modified signal (S') being defined by no*rmalized*

$$f_{a,b}(x) = \frac{f_{a,b}(x)}{RMS(f_{a,b}(x))} \ , \quad \text{with} \quad RMS(x) = \sqrt[2]{\frac{\sum_m |x_m|^2}{m}},$$ wherein m is the number of samples available after processing by the first function ($f_{a,b}$).

14. System for processing an encoded signal (S) received from a noisy channel, in particular with impulsive noise in wireless transmission, prior to the decoding of the signal by a decoder, the system comprising:

- a signal processing module adapted for applying to the encoded signal (S) a first function ($f_{a,b}$) based on at least two parameters (a, b) for obtaining a modified signal (S'), the first function being chosen so as to mitigate the influence of the channel noise during the decoding of the modified signal (S'),
- a parameter estimation module adapted for estimating said at least two parameters (a, b) beforehand by minimization of a second function ($J$) taking as input a signal ($AS$) obtained from the encoded signal (S) modified by a processing function using a random binary sequence.

15. System according to claim 14, comprising a module adapted for normalizing the amplitudes of the encoded signal ($S$) before estimation of the parameters (a, b) and application of the first function ($f_{a,b}$).

16. System according to claim 14 or 15, comprising a module adapted for normalizing the samples of the modified signal (S'), in particular by computing a RMS value, the normalized modified signal (S') being defined by *Normalized*

$$f_{a,b}(x) = \frac{f_{a,b}(x)}{RMS(f_{a,b}(x))}, \quad \text{with} \quad RMS(x) = \sqrt[2]{\frac{\sum_m |x_m|^2}{m}},$$ wherein m is the number of samples available after processing by the first function ($f_{a,b}$).

17. A computer program product for processing an encoded signal (S) received from a noisy channel, in particular with impulsive noise in wireless transmission, prior to the decoding of the signal by a decoder, the computer program product comprising a support and stored on this support instructions that can be read by a processor, these instructions being configured for:

- applying to the encoded signal (S) a first function ($f_{a,b}$) based on at least two parameters (a, b) for obtaining a modified signal (S') to be decoded, the first function being chosen so as to mitigate the influence of the channel noise during the decoding of the modified signal (S'), and
- estimating beforehand said at least two parameters (a, b) by minimizing a second function ($J$) taking as input a signal ($AS$) obtained from the encoded signal (S) modified by a processing function using a random binary sequence.

Fig.1

Fig.2

Fig.3

Continuous loop

USRP sampled
signal acquire → Useful signal
extraction → Resampling

Setup
Receiver

Demodulation &
Amplitude
extraction → Signal decoding → Message display
& Statistics
update

Processing of the encoded signal

Fig.4

Sampled
signal → Split incoming
signal → Process signal

Process signal

Process signal

Process signal

Recombine
results → Toward
signal
chop

Fig.5

Resampled
noisy signal → | Synchronization → Demodulation
with amplitude
extraction →

Fig.6

Baseband received waveform - No sync

Fig.7

Baseband received waveform - Sync

Fig.8

Fig.9

Fig.10

Fig.11

Fig.12

Europäisches
Patentamt

European
Patent Office

Office européen
des brevets

# EUROPEAN SEARCH REPORT

Application Number

EP 18 30 5464

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DIMANCHE VINCENT ET AL: "On Detection Method for Soft Iterative Decoding in the Presence of Impulsive Interference", IEEE COMMUNICATIONS LETTERS, IEEE SERVICE CENTER, PISCATAWAY, NJ, US, vol. 18, no. 6, 1 June 2014 (2014-06-01), pages 945-948, XP011550325, ISSN: 1089-7798, DOI: 10.1109/LCOMM.2014.2320921 [retrieved on 2014-06-06] * abstract * * equation (5); page 946, left-hand column - page 946, right-hand column * * page 948, left-hand column - page 948, right-hand column * | 1-17 | INV. H03M13/45 |
| A | DIMANCHE VINCENT ET AL: "Estimation of an approximated likelihood ratio for iterative decoding in impulsive environment", PROC. 2016 IEEE WIRELESS COMMUNICATIONS AND NETWORKING CONFERENCE, IEEE, 3 April 2016 (2016-04-03), pages 1-6, XP032959372, DOI: 10.1109/WCNC.2016.7565031 [retrieved on 2016-09-12] * abstract * * page 3, left-hand column - page 4, left-hand column * * figure 2 * | 1-17 | |
| | -/-- | | TECHNICAL FIELDS SEARCHED (IPC) H03M H04L |

The present search report has been drawn up for all claims

| Place of search | Date of completion of the search | Examiner |
|---|---|---|
| Munich | 28 September 2018 | Burkert, Frank |

Europäisches
Patentamt

European
Patent Office

Office européen
des brevets

# EUROPEAN SEARCH REPORT

Application Number

EP 18 30 5464

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HOU YI ET AL: "A non-linear LLR approximation for LDPC decoding over impulsive noise channels", PROC. 2014 IEEE/CIC INTERNATIONAL CONFERENCE ON COMMUNICATIONS IN CHINA (ICCC), IEEE, 13 October 2014 (2014-10-13), pages 86-90, XP032721806, DOI: 10.1109/ICCCHINA.2014.7008248 [retrieved on 2015-01-12] * abstract * * page 87, right-hand column - page 88, right-hand column * | 1-17 | |
| A | GAO CHENYU ET AL: "Gradient descent bit-flipping based on penalty factor for decoding LDPC codes over symmetric alpha-stable noise channels", PROC. 2017 IEEE/CIC INTERNATIONAL CONFERENCE ON COMMUNICATIONS IN CHINA (ICCC), IEEE, 22 October 2017 (2017-10-22), pages 1-4, XP033343368, DOI: 10.1109/ICCCHINA.2017.8330404 [retrieved on 2018-04-02] * abstract * * page 2, right-hand column * * figure 1 * | 1-17 | |
| A | US 2005/058302 A1 (DANCE CHRISTOPHER R [GB] ET AL) 17 March 2005 (2005-03-17) * abstract * * paragraph [0047] * * paragraph [0049] * * paragraphs [0088], [0089] * * paragraph [0091] - paragraph [0143] * * figures 2,8 * | 1-17 | TECHNICAL FIELDS SEARCHED (IPC) |

The present search report has been drawn up for all claims

| Place of search | Date of completion of the search | Examiner |
|---|---|---|
| Munich | 28 September 2018 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 30 5464

This annex lists the patent family members relating to the patent documents cited in the above-mentioned European search report.
The members are as contained in the European Patent Office EDP file on
The European Patent Office is in no way liable for these particulars which are merely given for the purpose of information.

28-09-2018

| Patent document cited in search report | Publication date | Patent family member(s) | Publication date |
|---|---|---|---|
| US 2005058302 A1 | 17-03-2005 | DE 69935410 T2<br>EP 1043872 A2<br>US 2005058302 A1 | 29-11-2007<br>11-10-2000<br>17-03-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Clipping demapper for LDPC decoding in impulsive channel. **HASSEN BENMAAD et al.** IEEE Communications Letters. Institute of Electrical and Electronics Engineers, 2013, vol. 17, 968-971
- **POULLIAT C. et al.** Performances des codes LDPCpour l'Ultra-Large Bande (ULB) impulsionnelle sous approximation gaussienne généralisée des interférences. *the proceedings of GRETSI conference,* 2007
- **CHUAN HSIAN.** Iterative SOVA decoding over alpha stable channels. *Journal of Engineering Science and Technology,* June 2012, vol. 7 (3
- **CHUAN HISIAN.** SOVA decoding in Symmetric Alpha-Stable Noise. *Symposium on Information & Computer Sciences,* 2011
- **M. JOHNSTON et al.** Sum-Product Algorithm Utilizing Soft Distances on Additive impulsive Noise Channels. *IEEE Transactions on Communications,* June 2013, vol. 61 (6), 2113-2116
- **WEI GUI.** Decoding Metric Study for Turbo Codes in Very impulsive Environment. *IEEE Communications Letters,* February 2012, vol. 16 (2), 256-258